# EUROPEAN PATENT APPLICATION

(11) **EP 4 447 103 A1**
(43) Date of publication of application: **16.10.2024**
(21) Application number: 24169422.3
(22) Date of filing: 10.04.2024
(51) Int. Cl.: H01L 23/31, H01L 23/00, H01L 23/498, H01L 23/50

(54) **SEMICONDUCTOR PACKAGE HAVING MOISTURE PASSING GAP IN POWER OR GROUND METAL PLANE OF A PACKAGE SUBSTRATE**

(30) Priority: 11.04.2023 US 202363495305 P; 20.03.2024 US 202418611681
(71) Applicant: MediaTek Inc., Hsin-Chu 300 (TW)
(72) Inventor: CHANG, Chu-Chia, 30078 Hsinchu City (TW); TSAO, Pei-Haw, 30078 Hsinchu City (TW); HUANG, Peng-Yu, 30078 Hsinchu City (TW); HSIAO, Yu-Liang, 30078 Hsinchu City (TW); CHEN, Wei-Fan, 30078 Hsinchu City (TW)
(74) Representative: Hoefer & Partner Patentanwälte mbB

(57) **Abstract**

A semiconductor package (1) includes a package substrate (100) having a top surface (S1) and an opposing bottom surface (S2). The package substrate (100) includes a top build-up wiring layer (MO) and an upper dielectric layer (110) covering the top build-up wiring layer (MO). A semiconductor device (10) and a passive component (20) are mounted on the top surface (S1) of the package substrate (100) in a side-by-side manner. A molding compound (50) encapsulates the semiconductor device (10) and the passive component (20) on the top surface (S1) of the package substrate (100). A cavity (CA) is disposed between the passive component (20) and the top surface (S1) of the package substrate (100). A moisture passing gap (GP1) is disposed in the top build-up wiring layer (MO) of the package substrate (100).

## Description

### Cross Reference to Related Applications

This application claims the benefit of U.S. Provisional Application No. 63/495,305, filed on April 11th, 2023. The content of the application is incorporated herein by reference.

### Background

The present disclosure relates generally to the field of semiconductor technology, and more particularly, to a semiconductor package having a moisture passing gap in the power or ground metal plane of a package substrate.

Passive components such as capacitors, resistors and inductors play an important role in electronic systems. For example, passive components help smooth signals and improve the performance of the active devices of the system.

Typically, the passive components are mounted on a package substrate and over-molded by a molding compound. A sealed cavity is usually formed between the passive component and the top surface of the package substrate under the mold cap. The sealed cavity is problematic because moisture retained in the cavity may cause reliability issues during the subsequent thermal processes, for example, re-flow processes.

### Summary

It is one object of the present invention to provide a semiconductor package in order to solve the prior art deficiencies or shortcomings. A semiconductor package according to the invention is defined in independent claim 1. The dependent claims define preferred embodiments thereof.

One aspect of the invention provides a semiconductor package including a package substrate having a top surface and an opposing bottom surface. The package substrate includes a top build-up wiring layer, an upper dielectric layer covering the top build-up wiring layer, a pad layer disposed over the upper dielectric layer on the top surface, and ball pads on the bottom surface. A semiconductor device is mounted on the top surface of the package substrate. A passive component is mounted on the top surface of the package substrate. A molding compound encapsulates the semiconductor device and the passive component on the top surface of the package substrate. A cavity is disposed between the passive component and the top surface of the package substrate. A moisture passing gap is disposed in the top build-up wiring layer of the package substrate.

Preferably, the package substrate comprises a ball grid array substrate.

Preferably, the passive component comprises a capacitor, an inductor, or a resistor.

Preferably, terminals of the passive component are electrically connected to respective bonding pads of the pad layer of the package substrate.

Preferably, the top build-up wiring layer functions as a power or ground plane.

Preferably, the moisture passing gap is filled with the upper dielectric layer.

Preferably, the moisture passing gap is aligned with the cavity and moisture retained in the cavity escapes through the moisture passing gap during thermal processes.

Preferably, the moisture passing gap has a width that is smaller than or equal to a width of the passive component.

Preferably, the moisture passing gap has a surface area that is smaller than or equal to a surface area of the passive component.

Preferably, the semiconductor package further includes solder balls mounted on the ball pads, respectively.

Another aspect of the invention provides a semiconductor package including a package substrate having a top surface and an opposing bottom surface. The package substrate includes a top build-up wiring layer, an upper dielectric layer covering the top build-up wiring layer, at least one inner insulating layer, at least one inner metal wiring layer, a pad layer disposed over the upper dielectric layer on the top surface, and ball pads on the bottom surface. A semiconductor device is mounted on the top surface of the package substrate. A passive component is mounted on the top surface of the package substrate. A molding compound encapsulates the semiconductor device and the passive component on the top surface of the package substrate. A cavity is disposed between the passive component and the top surface of the package substrate. A first moisture passing gap is disposed in the top build-up wiring layer of the package substrate. A second moisture passing gap is disposed in the at least one inner metal wiring layer of the package substrate.

Preferably, the package substrate comprises a ball grid array substrate.

Preferably, the passive component comprises a capacitor, an inductor, or a resistor.

Preferably, terminals of the passive component are electrically connected to respective bonding pads of the pad layer of the package substrate.

Preferably, the top build-up wiring layer functions as a power or ground plane.

Preferably, the first moisture passing gap is filled with the upper dielectric layer.

Preferably, the first moisture passing gap is aligned with the cavity and moisture retained in the cavity escapes through the first moisture passing gap during thermal processes.

Preferably, the first moisture passing gap has a width that is smaller than or equal to a width of the passive component, and the second moisture passing gap has a width that is smaller than or equal to the width of the passive component.

Preferably, the first moisture passing gap has a surface area that is smaller than or equal to a surface area of the passive component.

Preferably, the semiconductor package further includes solder balls mounted on the ball pads, respectively.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary semiconductor package in accordance with one embodiment of the invention; and
FIG. 2 is a schematic, cross-sectional diagram showing an exemplary semiconductor package in accordance with another embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

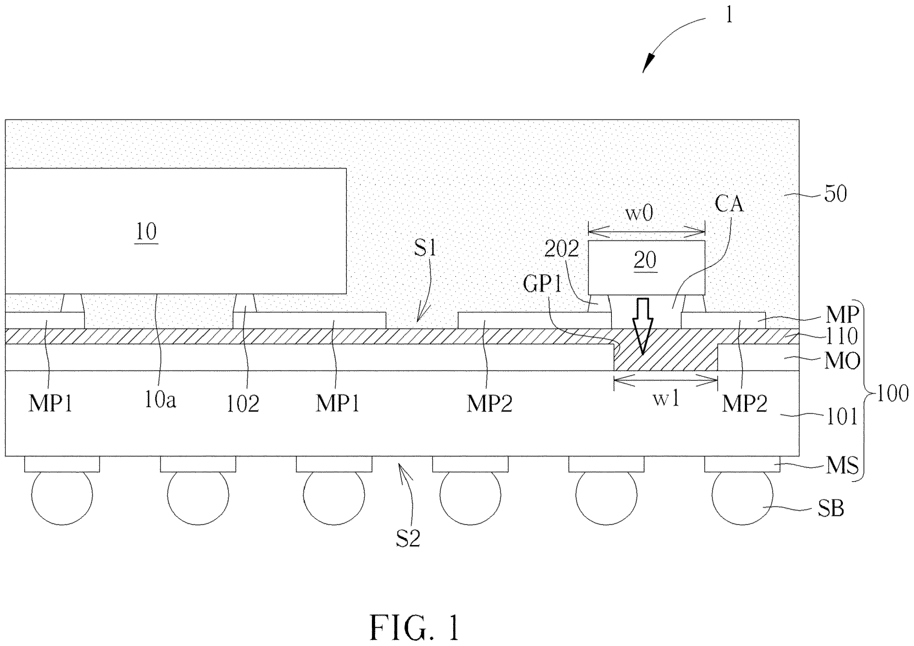

Please refer to FIG. 1. FIG. 1 is a schematic, cross-sectional diagram showing an exemplary semiconductor package in accordance with one embodiment of the invention. As shown in FIG.1, the semiconductor package 1 comprises a package substrate 100, for example, a ball grid array (BGA) substrate. The package substrate 100 has a top surface S1 and an opposing bottom surface S2. Preferably, the package substrate 100 may include, but not limited to, a core 101, a top build-up wiring layer MO, an upper dielectric layer 110 covering the top build-up wiring layer MO, a pad layer MP disposed over the upper dielectric layer 110 on the top surface S1, and ball pads MS on the bottom surface S2. Preferably, solder balls or BGA balls SB may be mounted on the ball pads MS, respectively.

Preferably, for example, the core 101 may comprise a copper clad laminate, but is not limited thereto. Preferably, for example, the top build-up wiring layer MO may be a power plane or a ground plane. It is understood that alternatively preferably the package substrate 100 may a coreless substrate.

Preferably, a semiconductor device 10 such as a semiconductor chip or die is mounted on the top surface S1 of the package substrate 100 in a flip chip fashion. Preferably, the active side 10a of the semiconductor device 10 may be directly connected to the respective bonding pads MP1 of the pad layer MP through connecting elements 102 such as solder bumps, metal pillars, micro-bumps or the like. Additionally or alternatively preferably, the semiconductor device 10 may be mounted on the top surface S1 in a wire bonding fashion.

Preferably, a passive component 20 is mounted on the top surface S1 of the package substrate 100. The passive component 20 may be disposed in proximity to the semiconductor device 10. Preferably, for example, the passive component 20 may comprise a capacitor, an inductor, or a resistor, but is not limited thereto. Preferably, the terminals of the passive component 20 may be electrically connected to the respective bonding pads MP2 of the pad layer MP of the package substrate 100.

Preferably, a molding compound 50 encapsulates the semiconductor device 10 and the passive component 20. Preferably, the passive component 20 is over-molded and a sealed cavity CA is formed between the passive component 20 and the top surface S1 of the package substrate 100. The cavity CA becomes a concern because moisture retained in the cavity CA may cause reliability problems during the subsequent thermal processes, for example, re-flow processes. The instant disclosure addresses this issue.

Preferably, a moisture passing gap GP1 is provided in the top build-up wiring layer MO that may function as a power or ground plane. Preferably, the moisture passing gap GP1 may be filled with the upper dielectric layer 110. Preferably, the moisture passing gap GP1 is generally aligned with the cavity CA such that moisture retained in the cavity CA can easily escape along the path as indicated by the arrow during the subsequent thermal processes. Preferably, the moisture passing gap GP1 is disposed directly under the passive component 20.

Preferably, for example, the moisture passing gap GP1 has a width w1 that is smaller than or equal to a width w0 of the passive component 20. Preferably, when viewed from the above, the moisture passing gap GP1 has a surface area that is smaller than or equal to a surface area of the passive component 20 in order not to affect the signal integrity of the power or ground plane.

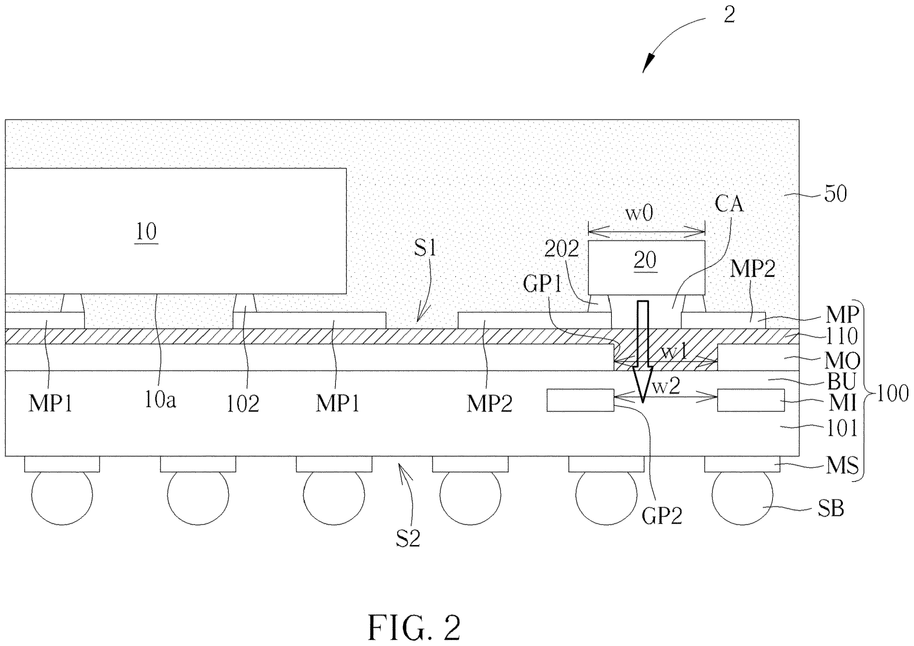

Please refer to FIG. 2. FIG. 2 is a schematic, cross-sectional diagram showing an exemplary semiconductor package in accordance with another embodiment of the invention. As shown in FIG.2, likewise, the semiconductor package 2 comprises a package substrate 100, for example, a ball grid array substrate. The package substrate 100 has a top surface S1 and an opposing bottom surface S2. Preferably, the package substrate 100 may include, but not limited to, a core 101, a top build-up wiring layer MO, an upper dielectric layer 110 covering the top build-up wiring layer MO, a pad layer MP disposed over the upper dielectric layer 110 on the top surface S1, and ball pads MS on the bottom surface S2. Preferably, solder balls or BGAballs SB may be mounted on the ball pads MS, respectively.

Preferably, the package substrate 100 may further comprise at least one insulating layer BU and at least one inner metal wiring layer MI. Preferably, for example, the core 101 may comprise a copper clad laminate, but is not limited thereto. Preferably, for example, the top build-up wiring layer MO may be a power plane or a ground plane. It is understood that alternatively preferably the package substrate 100 may a coreless substrate.

Preferably, a semiconductor device 10 such as a semiconductor chip or die is mounted on the top surface S1 of the package substrate 100 in a flip chip fashion. Preferably, the active side 10a of the semiconductor device 10 may be directly connected to the respective bonding pads MP1 of the pad layer MP through connecting elements 102 such as solder bumps, metal pillars, micro-bumps or the like. Additionally or alternatively preferably, the semiconductor device 10 may be mounted on the top surface S1 in a wire bonding fashion.

Preferably, a passive component 20 is mounted on the top surface S1 of the package substrate 100. The passive component 20 may be disposed in proximity to the semiconductor device 10. Preferably, for example, the passive component 20 may comprise a capacitor, an inductor, or a resistor, but is not limited thereto. Preferably, the terminals of the passive component 20 may be electrically connected to the respective bonding pads MP2 of the pad layer MP of the package substrate 100.

Preferably, a molding compound 50 encapsulates the semiconductor device 10 and the passive component 20. Preferably, the passive component 20 is over-molded and a sealed cavity CA is formed between the passive component 20 and the top surface S1 of the package substrate 100. Preferably, a first moisture passing gap GP1 is provided in the top build-up wiring layer MO. Preferably, the first moisture passing gap GP1 may be filled with the upper dielectric layer 110. Preferably, a second moisture passing gap GP2 is provided in the inner metal wiring layer MI.

Preferably, the first moisture passing gap GP1 and the second moisture passing gap GP2 may be aligned with the cavity CA such that moisture retained in the cavity CA can easily escape along the path as indicated by the arrow during the subsequent thermal processes.

Preferably, for example, the first moisture passing gap GP1 has a width w1 that is smaller than or equal to a width w0 of the passive component 20. Preferably, for example, the second moisture passing gap GP2 has a width w2 that is smaller than or equal to a width w0 of the passive component 20.Preferably, when viewed from the above, the first moisture passing gap GP1 has a surface area that is smaller than or equal to a surface area of the passive component 20.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (1; 2), comprising:
a package substrate (100) having a top surface (S1) and an opposing bottom surface (S2), wherein the package substrate (100) comprises a top build-up wiring layer (MO), an upper dielectric layer (110) covering the top build-up wiring layer (MO), a pad layer (MP) disposed over the upper dielectric layer (110) on the top surface (S1), and ball pads (MS) on the bottom surface (S2);
a semiconductor device (10) mounted on the top surface (S1) of the package substrate (100);
a passive component (20) mounted on the top surface (S1) of the package substrate (100);
a molding compound (50) encapsulating the semiconductor device (10) and the passive component (20) on the top surface (S1) of the package substrate (100);
a cavity (CA) disposed between the passive component (20) and the top surface (S1) of the package substrate (100); and
a first moisture passing gap (GP1) disposed in the top build-up wiring layer (MO) of the package substrate (100).

2. The semiconductor package (2) according to claim 1, wherein the package substrate (100) further comprises at least one inner insulating layer (BU) and at least one inner metal wiring layer (MI); and
the semiconductor package (2) further comprises:
a second moisture passing gap (GP2) disposed in the at least one inner metal wiring layer (MI) of the package substrate (100).

3. The semiconductor package (1; 2) according to claim 1 or 2, wherein the package substrate (100) comprises a ball grid array substrate.

4. The semiconductor package (1; 2) according to any one of claims 1 to 3, wherein the passive component (20) comprises a capacitor, an inductor, or a resistor.

5. The semiconductor package (1; 2) according to any one of claims 1 to 4, wherein terminals of the passive component (20) are electrically connected to respective bonding pads (MP2) of the pad layer (MP) of the package substrate (100).

6. The semiconductor package (1; 2) according to any one of claims 1 to 5, wherein the top build-up wiring layer (MO) functions as a power or ground plane.

7. The semiconductor package (1; 2) according to any one of claims 1 to 6, wherein the first moisture passing gap (GP1) is filled with the upper dielectric layer (110).

8. The semiconductor package (1; 2) according to any one of claims 1 to 7, wherein the first moisture passing gap (GP1) is aligned with the cavity (CA) and moisture retained in the cavity (CA) escapes through the first moisture passing gap (GP1) during thermal processes.

9. The semiconductor package (1; 2) according to any one of claims 1 to 8, wherein the first moisture passing gap (GP1) has a width (w1) that is smaller than or equal to a width (w0) of the passive component (20).

10. The semiconductor package (2) according to any one of claims 2 and 3 to 9 being directly or indirectly dependent on claim 2, wherein the second moisture passing gap (GP2) has a width (w2) that is smaller than or equal to the width (w0) of the passive component (20).

11. The semiconductor package (1; 2) according to any one of claims 1 to 10, wherein the first moisture passing gap (GP1) has a surface area that is smaller than or equal to a surface area of the passive component (20).

12. The semiconductor package (1; 2) according to any one of claims 1 to 11 further comprising: solder balls (SB) mounted on the ball pads (MS), respectively.
